# EUROPÄISCHE PATENTSCHRIFT

(11) **EP 2 443 673 B1**
(45) Veröffentlichungstag und Bekanntmachung des Hinweises auf die Patenterteilung: **02.10.2019**
(21) Anmeldenummer: 09779854.0
(22) Anmeldetag: 19.06.2009
(51) Int. Cl.: H01L 33/44, H01L 33/50, H01L 33/62

(54) **KONVERSIONS-LED MIT ERHÖHTER STABILITÄT UND VERFAHREN ZU IHRER HERSTELLUNG**
CONVERSION LED WITH INCREASED ROBUSTNESS, AND METHOD FOR THE PRODUCTION THEREOF
DIODE ÉLECTROLUMINESCENTE À CONVERSION À STABILITÉ ACCRUE ET PROCÉDÉ DE FABRICATION CORRESPONDANT

(43) Veröffentlichungstag der Anmeldung: 25.04.2012
(73) Patentinhaber: OSRAM GmbH, 80807 München (DE)
(72) Erfinder: BERBEN, Dirk, 86399 Bobingen (DE); JERMANN, Frank, 86343 Königsbrunn (DE)
(74) Vertreter: Epping - Hermann - Fischer
(86) Internationale Anmeldenummer: PCT/EP2009/057693
(87) Internationale Veröffentlichungsnummer: WO 2010/145716

(56) Entgegenhaltungen:
- WO-A-2008/060586
- US-A1- 2006 171 152
- US-A1- 2008 032 142

## Beschreibung

### Technisches Gebiet

Die Erfindung geht aus von einer Konversions-LED gemäß dem Oberbegriff des Anspruchs 1. Derartige Konversions-LEDs sind insbesondere für Allgemeinbeleuchtung geeignet.

### Stand der Technik

Aus der US 6 924 233 und WO 2007/024331 sind Methoden bekannt, um Leuchtstoffe auf Halbleitern abzuscheiden. Dabei handelt es sich insbesondere um elektrophoretische Abscheidung.

Aus der US 2008/032142 ist eine Konversions-LED bekannt, wobei die elektrisch leitenden Bauteile und der Chip von einer transparenten oxidischen Schutzschicht als Isolation umgeben sind. Ähnliches ist in US 2006/171152 und WO 2008/060586 offenbart. Letztere Schrift offenbart auch ein Verfahren zur Herstellung einer Konversions-LED, wobei die oxidische Schicht durch Heißpressen auf die LED aufgebracht wird.

### Darstellung der Erfindung

Die Aufgabe der vorliegenden Erfindung ist es, eine Konversions-LED bereitzustellen, die mit einem alterungsbeständigen Leuchtstoff ausgestattet ist, so dass die Konversions-LED insbesondere eine hohe nutzbare Lebensdauer erreicht. Diese Aufgabe wird gelöst durch die kennzeichnenden Merkmale des Anspruchs 1. Besonders vorteilhafte Ausgestaltungen finden sich in den abhängigen Ansprüchen.

Erfindungsgemäß wird jetzt Konversions-LED hoher Stabilität bereitgestellt. Nicht alle Leuchtstoffe sind beim Einbau in LEDs stabil. Dies gilt insbesondere für bei hohen Strömen ab etwa 200 mA betriebenen LEDs, sog. Hochleistungs-LED, die bis zu etwa 700 mA betrieben werden. Insbesondere gilt diese Problematik für nitridische oder oxinitridische Leuchtstoffe wie das Nitridosilikat M₂Si₅N₈ :Eu. Viele derartige Leuchtstoffe, insbesondere Nitride des Typs M₂Si₅N₈:D mit D als Aktivator erleiden beim Betrieb in einer LED deutliche Konversionsverluste. Beim sog. SSLT-Test ((Solid-State-Lighting: er bezeichnet einen Test, bei dem die LED mit Nennstrom und bei Wohnraumklima (21°C, ca. 50% rel. Luftfeuchte für 1000 h betrieben wird) werden LED mit bis zu 700 mA Dauerstrom vermessen. Bei diesem Test für weiße LEDs verlieren derartige Leuchtstoffe in kurzer Zeit (typisch 1000 Std.) bis zu 50% Konversionseffizienz. Dies führt zu einer ausgeprägten Instabilität des Farborts.

Bisher konnte dieses Problem dadurch gelöst werden, dass man sich auf Leuchtstoffe beschränkte, die hohe Stabilität zeigen. Allerdings bedeutet dies eine Einschränkung der Möglichkeiten, was die optischen Eigenschaften der LED wie Farbwiedergabe oder Effizienz betrifft. Erfindungsgemäß wird elektrolytisch eine Schutzschicht aufgebracht, die den Leuchtstoff gegen zerstörerische Einflüsse beispielsweise von Kriechströmen schützt. Diese Leuchtstoffe sind dann im SSLT-Test deutlich stabiler. Generell sind Leuchtstoffe, die dem hier wirkenden Alterungsprozess unterliegen, auf diese Weise stabilisiert. Dies gilt insbesondere für Oxinitride wie MSi202N2:Eu oder MAlSiN3:Eu. Insbesondere gilt dies auch für physikalisch interessanten, bisher wegen mangelnder Stabilität nicht einsetzbaren Orthosilikate, insbesondere des Typs M₂SiO₄ :Eu. Hier ist M insbesondere jeweils als Ca, Sr, Ba, Mg einzeln oder in Kombination wählbar.

Die Schutzschicht besteht hierbei aus transparenten Oxiden, insbesondere Y₂O₃ oder MgO₂. etc.

Für die elektrolytische Beschichtung wird eine im wesentlichen wasserfreie Lösung bereitgestellt, die insbesondere Azeton und/oder Propanol enthält sowie einen geeigneten Vorläufer des Metalls für die oxidische Schutzschicht. Insbesondere ist ein geeigneter Vorläufer ein Nitrat des Metalls. Im Falle, dass die wasserfreie Lösung keine geeignete Leitfähigkeit aufweist, wird diese durch Zugabe eines Elektrolyten, insbesondere hier Wasser, eingestellt.

Anschließend wird die LED in ein Bad dieser Lösung getaucht und ein Potentialdifferenz angelegt. dabei wird der Vorläufer entweder in das Oxid oder in ein Zwischenprodukt umgewandelt. Dieses Zwischen- oder Endprodukt setzt sich auf der eingetauchten LED ab. Bevorzugt wird als Metall für die oxidische Schutzschicht der LED Yttrium verwendet. Anschließend findet ein Trocknungsprozess bei Temperaturen von 100 bis 200°C statt, insbesondere 130 bis 165 °C.

Anschließend wird der gewünschte Leuchtstoff auf die LED aufgetragen, insbesondere als Verguss oder dünne Schicht wie an sich bekannt.

Im Falle der Entstehung eines Zwischenprodukts wird die Temperatur beim Trocknungsprozess darauf abgestimmt, dass sich das Zwischenprodukt bei diesem Trocknungsprozess in das gewünschte Endprodukt umwandelt. Ein bevorzugtes Zwischenprodukt ist Hydroxid, das sich im Trocknungsprozess in Oxid umwandelt.

Die einzelnen Verfahrensschritte dauern zwischen wenigen Sekunden bis zu etlichen Minuten, je nachdem welche Schichtdicke gewünscht wird.

Die so aufgebrachte Schutzschicht erschwert eine elektrochemische Zersetzung von dafür empfindlichen Leuchtstoffen. Dies gilt insbesondere für den Leuchtstoff M₂Si₅N₈ :Eu. Besonders wirksam ist dieses Verfahren beim Leuchtstoff M= Sr oder Ba allein oder in Kombination.

### Kurze Beschreibung der Zeichnungen

Im Folgenden soll die Erfindung anhand mehrerer Ausführungsbeispiele näher erläutert werden. Die Figuren zeigen:
- Fig. 1: eine Konversions-LED;
- Fig. 2: einen Vergleich der Verluste an Konvertereffizienz mit und ohne Schutzschicht.

### Bevorzugte Ausführungsform der Erfindung

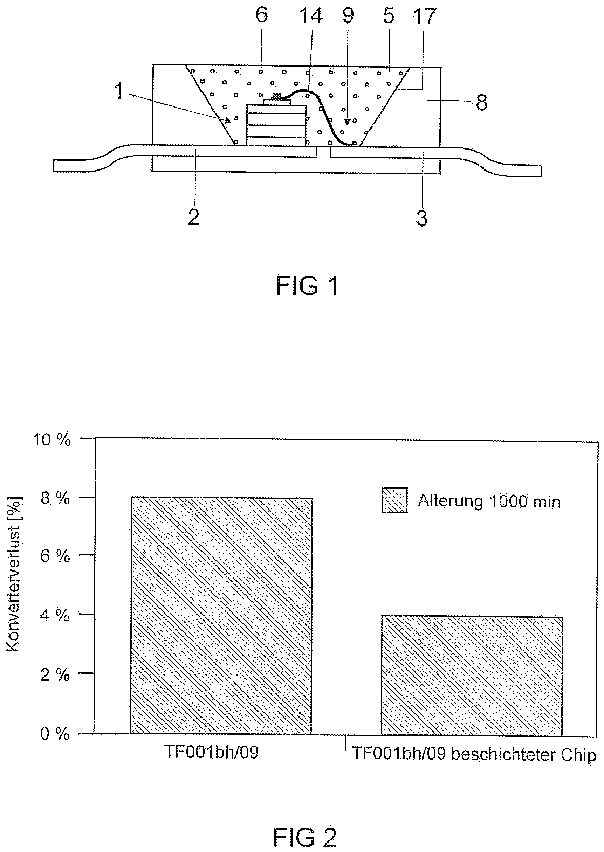

Figur 1 zeigt den Aufbau einer Konversions-LED für weißes Licht auf RGB-Basis wie an sich bekannt. Die Lichtquelle ist ein Halbleiterbauelement mit einem Chip 1 des Typs InGaN mit einer Peakemissionswellenlänge im UV von beispielsweise 405 nm, das in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Epoxidgießharz (80 bis 90 Gew.-%) und Leuchtstoffpigmente 6 (weniger als 20 Gew.-%) enthält. Ein erster Leuchtstoff ist ein grün emittierendes Oxinitridosilikat SrSi₂N₂O₂: (10 % Eu²⁺), das zweite ist ein blau emittierender Leuchtstoff, hier insbesondere BAM, sowie das rot emittierende Nitridosilikat (Sr,Ba)₂Si₅N₈:Eu unter Einschluss der reinen Sr und Ba-Variante sowie Mischungen aus Sr und Ba. Die Ausnehmung hat eine Wand 17, die als Reflektor für die Primär- und Sekundärstrahlung vom Chip 1 bzw. den Pigmenten 6 dient.

Figur 2 zeigt einen Vergleich zweier ansonsten gleichartiger Konversions-LEDs mit und ohne Schutzschicht. Bei einer unbeschichteten LED beträgt der Konversionsverlust bei einer beschleunigten Alterung über 1000 min 8 %, wird jedoch eine Y₂O₃-Schutzschicht aufgebracht, reduziert sich der Konversionsverlust in der gleichen Zeit auf die Hälfte.

Das Verfahren des Aufbringens der Schutzschicht verläuft hier wie folgt:
Die Konversions-LED wird in eine Lösung aus Azeton, Propanol und ggf. Wasser getaucht. Das Verhältnis Azeton:Propanol ist etwa 3:1. Es kann insbesondere zwischen 2:1 und 5:1 liegen. Der Anteil des Wassers liegt unter 5% (diese Angaben beziehen sich jeweils auf das Volumen). Er sollte bevorzugt zwischen 0,5 und 3% liegen.

Dieser Lösung werden typisch 5 bis 15 mg/l Yttriumnitrat zugesetzt. Anschließend wird die LED auf ein Potential von -200 V gelegt. Gegenüber der Konversions-LED befindet sich im Bad eine Elektrode auf Null-Potential. Bei Anlegen der Spannung wandern gelöste Y(NO₃)₃-Moleküle in Richtung leitfähiger Teile der LED. An der LED wird das Nitrat elektrochemisch zu Y(OH)₃ umgelagert. Da das Hydroxid schwerlöslich ist, verbleibt es an der LED. Dieser Beschichtungsvorgang dauert je nach gewünschter Schichtdicke nur wenige Sekunden bis hin zu einigen Minuten. Ein nutzbares Zeitfenster ist 1 sec bis 10 min.

Nach der Beschichtung wird die mit dem Hydroxid beschichtete Konversions-LED bei etwa 130 bis 155 °C im Vakuum getrocknet ("ausgebacken"). Dieser Trocknungsprozess findet routinemäßig bei der Herstellung einer LED ohnehin statt, so dass hier kein zusätzliche Aufwand entsteht. Er dient dazu, Wasserspuren zu entfernen. Bei diesem Trocknungsprozess zersetzt sich das Hydroxid in das gewünschte Oxid, welches die eigentliche stabile Schutzschicht bildet. Die so aufgebrachte Schutzschicht vermindert eine Zersetzung besonders effektiv bei (SrₓBa₁₋ₓ)_{2-y}EuySi₅N₈.

Somit sind alle elektrisch leitenden Bauteile und der Chip von einer transparenten oxidischen Schutzschicht als Isolation umgeben. Diese Schutzschicht umgibt diese Bauteile vollständig oder im wesentlichen vollständig.

Bei dieser Art von Beschichtung werden alle elektrisch leitenden Teile der LED, also Chip, Bonddraht, Leadframe etc. beschichtet. Ausnahmen sind allenfalls außen liegende Teile, mit denen die LED festgelötet wird. Dadurch werden Kriechströme und dadurch bedingte elektrochemische Prozesse im Leuchtstoff verringert. Es wird hier also nicht der Leuchtstoff als solcher beschichtet, sondern es handelt sich um eine elektrische Isolation stromführender LED-Bestandteile gegen den den Leuchtstoff enthaltenden Verguss bzw. gegen eine Leuchtstoff-Schicht, insbesondere eine direkt auf den Chip aufgebrachte Leuchtstoff-Schicht. Damit wird der elektrochemische Prozess unterbunden, der bei dafür anfälligen Leuchtstoffen wie Nitridosilikaten oder Oxinitridosilikaten, Orthosilikaten etc. zur vorzeitigen Alterung führt.

Erst nach dieser Beschichtung wird der Leuchtstoff auf die LED aufgetragen, insbesondere als Verguss-Schicht oder per layer-transfer im Falle dünner Schichten.

## Patentansprüche

1. Konversions-Lichtemittierende Diode (Konversions-LED) mit einem Chip (1), weiteren elektrisch leitenden Bauteilen, elektrisch isolierenden Bauteilen, sowie einer dem Chip (1) vorgelagerten Leuchtstoff (6) enthaltenden Schicht (5), die mindestens einen Teil der primären Strahlung des Chips (1) in sekundäre Strahlung konvertiert, **dadurch gekennzeichnet, dass** elektrisch leitende Bauteile und der Chip (1) von einer transparenten oxidischen Schutzschicht als Isolation umgeben sind, wobei die oxidische Schutzschicht ein Metalloxid ist oder enthält, wobei das Metalloxid Y₂O₃ oder MgO₂ ist.

2. Konversions-LED nach Anspruch 1, **dadurch gekennzeichnet, dass** die Leuchtstoff (6) enthaltende Schicht (5) ein Verguss oder ein oder mehrere dünne Schichten sind.

3. Konversions-LED nach Anspruch 1, **dadurch gekennzeichnet, dass** mindestens ein Leuchtstoff ausgewählt ist aus der Gruppe Nitridosilikate, Oxi-Nitridosilikate, Orthosilikate, Sialone, Calsine.

4. Verfahren zur Herstellung einer Konversions-Lichtemittierenden Diode (Konversions-LED) mit einem Chip (1), weiteren elektrisch leitenden Bauteilen, elektrisch isolierenden Bauteilen, sowie einer dem Chip (1) vorgelagerten Leuchtstoff (6) enthaltenden Schicht (5), die mindestens einen Teil der primären Strahlung des Chips (1) in sekundäre Strahlung konvertiert, wobei elektrisch leitende Bauteile und der Chip (1) von einer transparenten oxidischen Schutzschicht als Isolation umgeben sind, **dadurch gekennzeichnet, dass** folgende Schritte ausgeführt werden:
- Bereitstellen eines Bads, das im wesentlichen eine Lösung von Azeton und/oder Propanol enthält, dem ein Vorläufer der oxidischen Schutzschicht beigemengt ist;
- Eintauchen einer LED in das Bad und Anlegen einer Spannung, wobei das Bad eine Gegenelektrode enthält, so dass eine ausreichend dicke Schicht eines Zwischen- oder Endprodukts sich auf elektrisch leitenden Teilen absetzt;
- Trocknen der LED bei einer Temperatur von mindestens 100°C, wobei sich ggf. das Zwischenprodukt in das gewünschte Endprodukt umwandelt;
- Aufbringen einer Leuchtstoff enthaltenden Schicht auf die LED, so dass eine Konversions-LED entsteht.

## Claims

1. A conversion light-emitting diode (conversion LED) with a chip (1), further electrically conductive components, electrically insulating components, as well as a phosphor (6) containing layer (5) upstream of the chip (1), which converts at least a part of the primary radiation of the chip (1) into secondary radiation, **characterized in that** electrically conductive components and the chip (1) are surrounded by a transparent oxidic protective layer as insulation, wherein the oxidic protective layer is or contains a metal oxide, wherein the metal oxide is Y₂O₃ or MgO₂.

2. The conversion LED according to claim 1, **characterized in that** the phosphor (6) containing layer (5) are an encapsulation or one or more thin layers.

3. The conversion LED according to claim 1, **characterized in that** at least one phosphor is selected from the group of nitridosilicates, oxi-nitridosilicates, orthosilicates, sialons, calsins.

4. A method for producing a conversion light-emitting diode (conversion LED) with a chip (1), further electrically conductive components, electrically insulating components, and a phosphor (6) containing layer (5) upstream of the chip (1), which converts at least a part of the primary radiation of the chip (1) into secondary radiation, wherein electrically conductive components and the chip (1) are surrounded by a transparent oxidic protective layer as insulation, **characterised in that** the following steps are carried out:
- providing a bath substantially containing a solution of acetone and/or propanol to which a precursor of the oxidic protective layer is added;
- immersing an LED in the bath and applying a voltage, wherein the bath contains a counter electrode so that a sufficiently thick layer of an intermediate or final product is deposited on electrically conductive parts;
- drying the LED at a temperature of at least 100°C, wherein, if necessary, the intermediate product converts into the desired final product;
- applying a phosphor containing layer on the LED so that a conversion LED is formed.

## Revendications

1. Diode électroluminescente à conversion (DEL à conversion) dotée d'une puce (1), d'autres pièces électroconductrices, de pièces d'isolation électrique ainsi que d'une couche (5) en amont de la puce (1) qui contient de la substance luminescente (6) et qui convertit au moins une partie du rayonnement primaire de la puce (1) en rayonnement secondaire, **caractérisée en ce que** des pièces électroconductrices et la puce (1) sont entourées d'une couche d'oxyde de protection transparente en tant qu'isolant, la couche d'oxyde de protection étant ou contenant un oxyde métallique, ledit oxyde métallique étant de l'Y₂O₃ ou du MgO₂.

2. DEL à conversion selon la revendication 1, **caractérisée en ce que** la couche (5) contenant de la substance luminescente (6) est un scellement ou une ou plusieurs couches minces.

3. DEL à conversion selon la revendication 1, caractérisée en ce qu'au moins une substance luminescente est choisie parmi les silicates de nitrure, les silicates d'oxyni-trure, les orthosilicates, les sialones et les calsins.

4. Procédé de fabrication d'une diode électroluminescente à conversion (DEL à conversion) dotée d'une puce (1), d'autres pièces électroconductrices, de pièces d'isolation électrique ainsi que d'une couche (5) en amont de la puce (1) qui contient de la substance luminescente (6) et qui convertit au moins une partie du rayonnement primaire de la puce (1) en rayonnement secondaire, des pièces électroconductrices et la puce (1) étant entourées d'une couche d'oxyde de protection transparente en tant qu'isolant, **caractérisé en ce que** les étapes suivantes sont exécutées:
- fourniture d'un bain qui contient sensiblement une solution d'acétone et/ou de propanol et auquel est mélangé un précurseur de la couche d'oxyde de protection;
- plongée d'une DEL dans ledit bain et application d'une tension, ledit bain contenant une contre-électrode, de sorte qu'une couche suffisamment épaisse d'un produit intermédiaire ou final se dépose sur des pièces électroconductrices;
- séchage de la DEL à une température d'au moins 100 °C, le produit intermédiaire se transformant le cas échéant dans le produit final souhaité;
- application d'une couche contenant de la substance luminescente sur la DEL, de sorte qu'est créée une DEL à conversion.
